Europäisches Patentamt

European Patent Office

Office européen des brevets

(19)

(11) EP 0 364 987 B1

(12) EUROPEAN PATENT SPECIFICATION

(45) Date of publication and mention
of the grant of the patent:
**22.05.1996 Bulletin 1996/21**

(51) Int Cl.$^6$: **G11C 11/56**, G06G 7/60,
G06E 3/00, G02F 3/02

(21) Application number: **89119349.2**

(22) Date of filing: **18.10.1989**

(54) **Semiconductor device**

Halbleitervorrichtung

Dispositif à semi-conducteur

(84) Designated Contracting States:
**DE FR GB NL**

(30) Priority: **21.10.1988 JP 263892/88
10.01.1989 JP 1390/89**

(43) Date of publication of application:
**25.04.1990 Bulletin 1990/17**

(73) Proprietor: **HITACHI, LTD.
Chiyoda-ku, Tokyo 100 (JP)**

(72) Inventors:
• **Tanoue, Tomonori
Ebina-shi (JP)**
• **Mizuta, Hiroshi
Madingley Road Cambridge CB3 0HE (GB)**
• **Takahashi, Susumu
Nishitama-gun Tokyo (JP)**

(74) Representative:
**Strehl Schübel-Hopf Groening & Partner
Maximilianstrasse 54
80538 München (DE)**

(56) References cited:
**EP-A- 0 297 778        WO-A-87/02478**

• **TECHNICAL DIGEST OF GAAS IC SYMPOSIUM,
Portland, Oregon 13th - 16th October 1987,
pages 61-64, IEEE, New York, US; S. SEN et al.:
"Integration of GaAs/AlAs resonant tunneling
diodes for digital and analog applications with
reduced circuit complexity"**

• **IDEM**
• **COMPUTER, vol. 21, no. 3, March 1988, pages
41-48, IEEE, New York, US; H.P. GRAF et al.:
"VLSI implementation of a neural network
model"**
• **IDEM**
• **EDN - ELECTRICAL DESIGN NEWS, vol. 33, no.
10, 12th May 1988, pages 138-144, Newton, PA,
US; D. CONNER: "Data transformation explains
the basics of neural networks"**
• **OPTICAL ENGINEERING, vol. 25, no. 1, January
1986, pages 3-14, Bellingham, Washington, US;
G. ABRAHAM: "Multiple-valued logic for
optoelectronics"**
• **IDEM**
• **JOURNAL OF LIGHTWAVE TECHNOLOGY, vol.
LT-5, no. 10, October 1987, pages 1382- 1390,
IEEE, New York, US; H. MATSUEDA: "AlGaAs
OEIC transmitters"**
• **COMPUTER DESIGN, vol. 26, no. 5, 1st March
1987, pages 47-62, Littleton, MA, US; T.
WILLIAMS: "Optics and neural nets: trying to
model the human brain"**
• **ELECTRONICS LETTERS, vol. 24, no. 1, 7th
January 1988, pages 1-2, Stevenage, Herts, GB;
H. SAKAKI et al.: "Novel quantum-well optical
bistability device with excellent on/off ratio and
high speed capability"**
• **IEEE INTERNATIONAL CONFERENCE ON
NEURAL NETWORKS, San Diego, CA, 24th - 27th
July 1988, pages 411-419, IEEE, New York, US;
J. SINGH et al.: "Implementation of neural
networks using quantum well based excitonic
devices - device requirement studies"**

## Description

### BACKGROUND OF THE INVENTION

The present invention relates to a semiconductor device suitable for constructing a neural network.

A neuro chip, in which an electronic circuit or a neural network substituted for neurons, which are elements constituting a neural network represented by a cerebrum and the function of the synapse, which is a coupling element between neurons in/outputting signals in/from the neurons, is realized on a semiconductor chip, is discussed e.g. in "Nikkei Micro Device (in Japanese)", July 1988, pp. 53-65.

The synapse, which is an important constituting element in a neuro chip as described above, is constructed e.g. by a variable conductance circuit and a neuron is composed of an operational amplifying circuit.

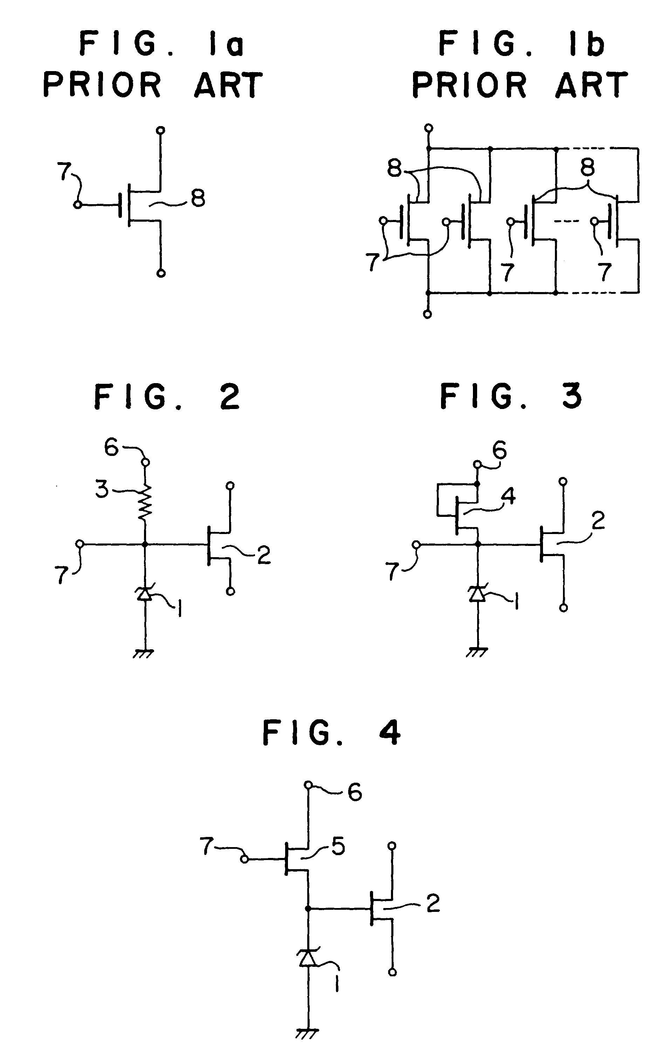

Heretofore, in order to realize a variable conductance circuit, MOSFETs have been used. For example, as indicated in Fig. 1a, it is possible to vary the channel conductance by varying the amount of electric charge stored in the gate 7 of a MOSFET 8. Further, as indicated in Fig. 1b, the conductance can be varied by connecting a number of FETs in parallel and by varying the number of FETs, which are in the on-state.

However, the method indicated in Fig. 1a has a problem from the point of view of the precision, the reproducibility and the reliability of the conductance, because the amount of the stored electric charge varies in the course of time because of the existence of leak current. On the other hand the method indicated in Fig. 1b has a problem that the number of FETs connected in parallel is too great and as the result the density cannot be increased, when it is intended to integrate them.

It is also tried to realize a neural network by using optical techniques and a synapse, in which a spacial light modulator, a hologram or an emulsion mask is used, is reported, ibid. pp. 66-71. Further, as an optical bistable element, whose transmission coefficient for input light varies in 2 levels, a semiconductor element, in which a double barrier resonant tunneling diode is combined with a p-n junction diode having a multiple quantum well structure, is described in "Technical Research Report of the Electronic Information Communication Society (in Japanese)" Vol. 88, No. 6, pp. 63-67 (1988).

It is expected that wiring, which would be complicated, if it were fabricated in the form of an electronic circuit, can be simplified by using light.

In the prior art neuro system, a neural network system using a special light modulator tube as a synapse stores a signal light pattern in the form of a pattern of electric charge formed on a surface of an $LiNbO_3$ crystal and the stored information is read out by using a laser light beam. Further in a system using a hologram as a synapse an $LiNbO_3$ crystal is used as the hologram material and the interference fringe of the signal light with the reference light is memorized. For these reasons, in these systems, it can be relatively easily effected to rewrite the stored information, which is inevitable for the learning function. However, since the construction of these systems is of large scale and complicated, it is difficult to try to integrate them.

On the other hand, in a system, in which an emulsion mask is used as the synapse, it is possible to form it on one chip by dividing the emulsion mask into a number of regions in a matrix form and by storing the transmission coefficient of each of the regions while varrying it with weight of $\pm0$, $\pm1$, $\pm2$. However, the information, which has been once written in the mask, is fixed and since it cannot be rewritten, the system has no learning function.

On the other hand, in the optical bistable element, in which a double barrier resonant tunneling diode is combined with a p-n junction diode having a multiple quantum well structure, the transmission coefficient for the input light can be varied only in two levels and therefore the multiple-valued logic signal processing, which is inevitable for a neuron system, is impossible.

Further, from TECHNICAL DIGEST OF GAAS IC SYMPOSIUM, Portland, Oregon, 13th-16th October 1987, Pages 61-64, IEEE, New York, US; S. SEN et al.: "Integration of GaAs/AlAs resonant tunneling diodes for digital and analog applications with reduced circuit complexity" a multi-voltage level circuit having a multi-negative differential resistance element comprising of two diodes is known.

OPTICAL ENGINEERING, vol. 25, no. 1, January 1986, pages 3-14, Bellingham, Washington, US; G.ABRAHAM: "Multiple-valued logic for optoelectronics" describes a semiconductor device including the features of the first part of claim 1.

### SUMMARY OF THE INVENTION

It is the object of the present invention to provide a semiconductor device having a multi-voltage level circuit with a negative differential resistance characteristic suitable for high density integration.

This object is met by a semiconductor device according to claim 1.

Preferred embodiments are disclosed in the depending claims.

According to the invention a multiple level variable conductance circuits are arranged having a multiple negative differential resistance element with a negative differential resistance characteristic at at least two places in the current-voltage characteristic, a load element therefor and a variable conductance element connected with the connecting point between the multiple negative differential resistance element and the load element in a series connection.

Further, an optical multi-stable element consisting of a multiple negative differential resistor and a p-i-n junction diode having a multiple quantum well structure can be achieved.

## BRIEF DESCRIPTION OF THE DRAWINGS

Figs. 1a and 1b show prior art variable conductance circuits;

Figs. 2, 3 and 4 show multiple level variable conductance circuits according to the present invention;

Figs. 5a and 5b are schemes indicating electric characteristics for explaining the operation of the multiple level variable conductance circuits according to the present invention;

Figs. 6 and 12 are schemes illustrating circuits, to which the multiple level variable conductance according to the present invention is applied;

Figs. 7 and 8 are cross-sectional views of multiple level variable conductance elements according to the present invention;

Fig. 9 is a partial cross-sectional view of a multiple level variable conductance element according to the present invention;

Figs. 10a, 10b and 10c are equivalent circuit diagrams of multiple level variable conductance elements according to the present invention;

Fig. 11 is a scheme illustrating the circuit diagram of the neuro chip;

Fig. 13a is a cross-sectional view of an optical multistable element;

Fig. 13b is a scheme for explaining the point of operation of the optical multi-stable device according to the present invention;

Fig. 13c is a graph showing variations in the light absorption coefficient of a multiple quantum well p-i-n diode constituting the optical multi-stable device;

Fig. 14a is a perspective view of an optical filter, in which optical multi-stable elements are arranged in a matrix form;

Fig. 14b is a block diagram indicating the construction of an optical neuro system, in which the optical multi-stable elements are used as synapses;

Figs. 15a to 15e are cross-sectional views showing fabrication steps of the light multi-stable element;

Fig. 15f is a graph for explaining the operation of the light multi-stable element ; and

Fig. 16 is a scheme of a pattern recognizing device, in which light multi-stable elements are arranged in a matrix form as synapses.

## DETAILED DESCRIPTION OF THE PREFERRED EMBODIMENTS

At first, a case where a multiple level variable conductance element is used as a synapse is explained.

In a multiple level variable conductance element having the construction described previously, it is possible to restrict the conductance, which the variable conductance element can have, to several discrete values by using a multiple negative differential resistor and a load. In this way the reproducibility of the signal outputted from the variable conductance and the setting precision are improved. Further, owing thereto, it is possible to read out the output signal with a high precision. In addition, since the number of elements is small, it becomes easier to integrate them.

Hereinbelow the preferred embodiments of the present invention will be described, referring to the drawings.

## EMBODIMENT 1

Fig. 2 is a circuit diagram indicating a multiple level variable conductance circuit according to the present invention.

In Fig. 2, reference numeral 1 is a multiple negative differential resistor; 2 is an FET having a variable conductance; 3 is a load resistor; 6 is a power source terminal; and 7 is a control voltage input terminal.

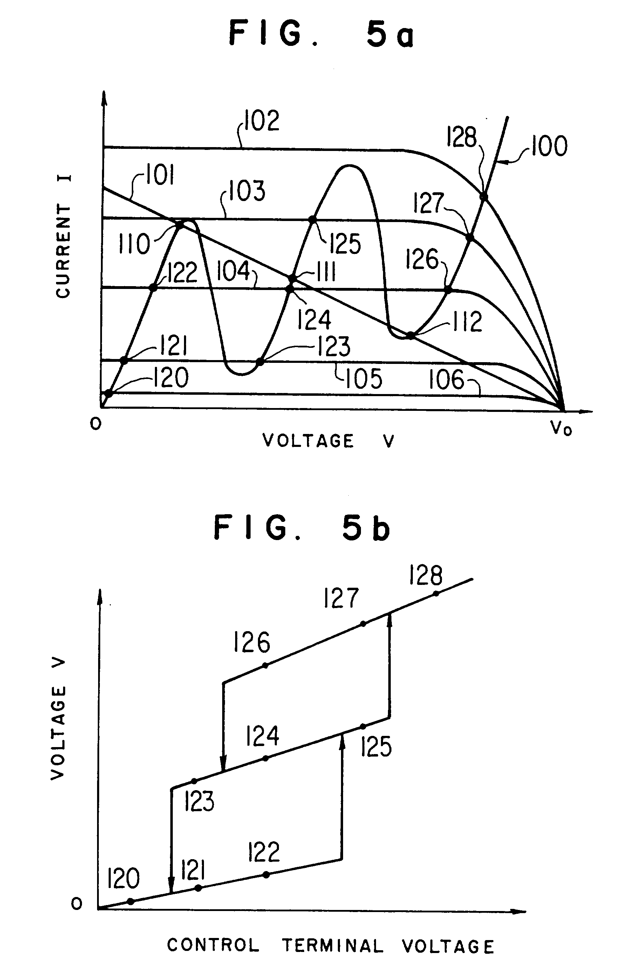

The multiple negative differential resistor 1 stated above has current-voltage characteristics as indicated by a curve 100 in Fig. 5a. Although the characteristics of the curve 100 indicated in Fig. 5a are double negative resistance characteristics, since there are no significant differences in the essential circuit operation from the case of the double negative resistor also for elements having triple or more multiple negative resistance characteristics, hereinbelow the operation will be explained by using the double negative resistance characteristics, i.e. the curve 100 indicated in Fig. 5a. The characteristics as indicated by the curve 100 in Fig. 5a can be realized by connecting usual negative resistance elements in series.

In the circuit indicated in Fig. 2, denoting the power source voltage by $V_0$ and the voltage applied to the multiple negative differential resistance element 1 (hereinbelow called simply element 1) by V, the voltage applied to the load resistor 3 is equal to $V_0$ - V. Since the current flowing through the gate of the FET 2 can be neglected, the current flowing through the element 1 is equal to the current flowing through the load resistor 3, which is represented by I. Further, since the voltage drop across the load resistor is represented by the product of the resistance R of the load resistor 3 and the current I,

$$V_0 - V = R \cdot I \qquad (1)$$

is valid, which can be rewritten to

$$V = V_0 - R \cdot I \qquad (1)'$$

The characteristics represented by Eq. (1)′ are indicated by a straight line 101 in Fig. 5a.

As it is clear from the above description, intersections of the straight line 101 with the curve 100 are points of operation of this circuit. Among them those which are stable are 3 points, 110, 111 and 112. That is, the gate potential of the FET 2 should be the potential represented by either one of 110, 111 and 112. The switching-over of these potentials can be effected by grounding the control voltage input terminal 7 through a resistor having a suitable resistance.

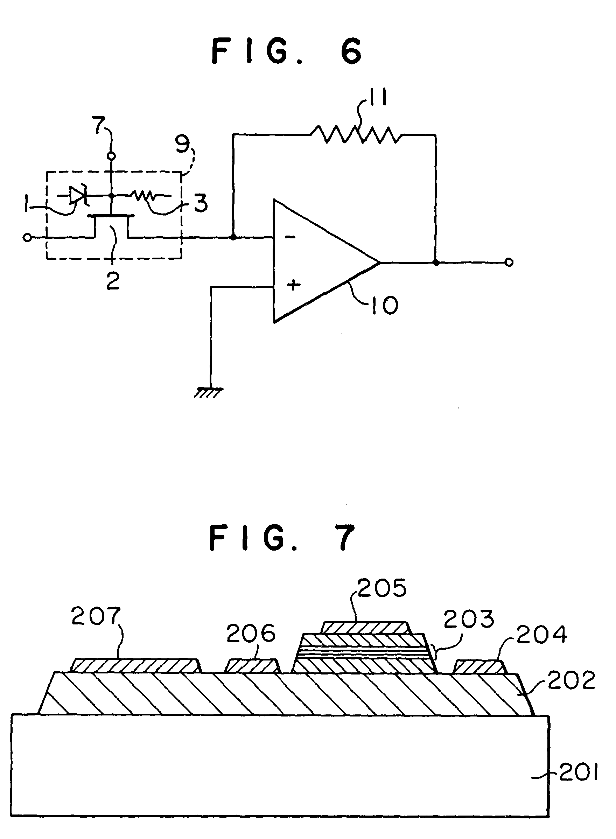

Considering now an operational amplifier having an FET represented by the FET 2 in Fig. 2 as the input conductance, it can be expressed as indicated in Fig. 6. Further, circuits described later, in which FETs are used as load resistors, as indicated in Figs. 3 and 4, can be similarly applied thereto instead of the circuit indicated in Fig. 2.

In Fig. 6, the input conductance circuit 9 corresponds to the circuit indicated in Fig. 2. The FET 2 in Fig. 2 is connected as the input conductance, as indicated in the Figure. In this circuit, since the input terminal of the operational amplifier 10 is at a vitual ground voltage, the voltage between the source and the gate of the FET 2 constituting the input conductance is equal to the voltage V applied to the element 1. Consequently the conductance of the FET 2 is varied in multiple levels by varying the voltage V in multiple levels, as described previously. In the operational amplifier circuit indicated in Fig. 6, since the amplification factor is represented by the product of the value of the input conductance and the resistance of the feedback resistor 11, it is possible to vary the amplification factor of this operational amplifier circuit.

According to the present invention, it is possible to vary the conductance in multiple levels by using a small number of elements with a high precision, a high reproducibility and a high reliability.

EMBODIMENT 2

Fig. 3 is a circuit diagram of another multiple level variable conductance according to the present invention.

This multiple level variable conductance is a circuit, in which the load resistor 3 indicated in Fig. 2 described previously is replaced by a normally-on type load FET 4.

There are differences in the current-voltage characteristics, depending on whether the load is a resistor or an FET. As the result, in the present embodiment, a curve 104 in Fig. 5a corresponds to the straight line 101 in the same figure. As the result, points of operation are represented by 122, 124 and 126.

Since the multiple level variable conductance indicated in the present embodiment requires no resistor element and it can be constructed only by two kinds of elements, i.e. FETs and a multiple negative differential resistor, no fabrication step for forming resistor elements is necessary at the integration and therefore it is more advantageous than that indicated EMBODIMENT 1 described above.

EMBODIMENT 3

Fig. 4 is a circuit diagram of still another multiple variable conductance according to the present invention.

The present circuit differs from that indicated in Fig. 3 consists in that the control voltage input terminal 7 is the gate terminal of the load FET 5. For this reason, the load curve varies, depending on the gate voltage, i.e. the potential at the control voltage input terminal 7 in Fig. 4, as indicated by curves 102 to 106 in Fig. 5a. For example, in the case where the load curve is represented by 106, the point of operation is at 120. Next, when the potential at the control voltage input terminal 7 is varied so that the load curve is changed to 105 or 104, the point of operation is changed to 121 or 122. Further, when the load curve is changed to 103, a jump of the point of operation takes place and the point of operation is at 125. At this time, when the control voltage is varied so that the load curve returns to 104, the point of operation goes to 124.

Fig. 5b indicates the operation described above in a graph, the ordinate representing the voltage at the working point, the abscissa the control terminal voltage. The voltages at the points of operation indicated in Fig. 5a are also indicated in the figure. Arrows in the figure indicate the direction of the jump of the point of operation. For example, the points 122, 124 and 126 are on a same load curve and it can be easily understood from Fig. 5b that the switching over among them can be effected by varying the control terminal voltage in a short pulse shape and returning it thereafter to the initial value. That is, in this case, it is possible to switch over the point of operation by using a pulsed voltage signal from the exterior and therefore the present mode of realization has an advantage that the external circuit can be simplified. The pulse duration of this pulsed voltage signal can be determined, depending on time constants such as the response time of the FETs and the negative resistor element, delay time determined by parasitic capacitance of wiring, etc. and the resistance, etc. However it is desirable that it is more than 3 times as long as the time constants described above.

Furthermore the parts, in which FETs are used in EMBODIMENTs 1, 2 and 3, can be operated similarly also by using bipolar transistors instead thereof.

EMBODIMENT 4

Fig. 7 is a cross-sectional view illustrating the construction of a semiconductor device realizing the part of the multiple negative differential resistor and the load FET in a multiple level variable conductance circuit according to the present invention.

In Fig. 7, an n conductivity type GaAs channel layer 202 (n: $2 \times 10^{17}/cm^3$, 200 nm (2000 Å) thick), a multiple level negative resistance diode 203 (multiple negative differential resistance element), ohmic electrodes 204, 205 and 207, and a Schottky gate electrode 206 are formed on a semi-insulating GaAs substrate 201.

The ohmic electrodes 204, 205 and 207 are made of an AuGe alloy and the Schottky gate electrode 206 is made of Al. However any other materials can be used for them, if they can form ohmic contacts and a Schottky contact, respectively.

Further, the multiple negative resistance diode 203 has a structure, in which a quantum well layer consisting of an AlAs layer 2 nm (20 Å) thick, a GaAs layer 5 nm thick and an AlAs layer 2 nm thick (double barrier structure, all of them are undoped) and an n conductivity type GaAs (n: $1 \times 10^{18}/cm^3$) 50 nm thick are superposed alternately on each other two times and the whole is put up and down between 2 n conductivity type GaAs layers (n: $1 \times 10^{18}/cm^3$) 200 nm thick. Although, in the present embodiment, 2 quantum well layers are used in order to realize the double negative differential resistance characteristics, the number of superposition of quantum well layers may be increased correspondingly in order to realize triple, quadruple or more multiple negative resistance characteristics.

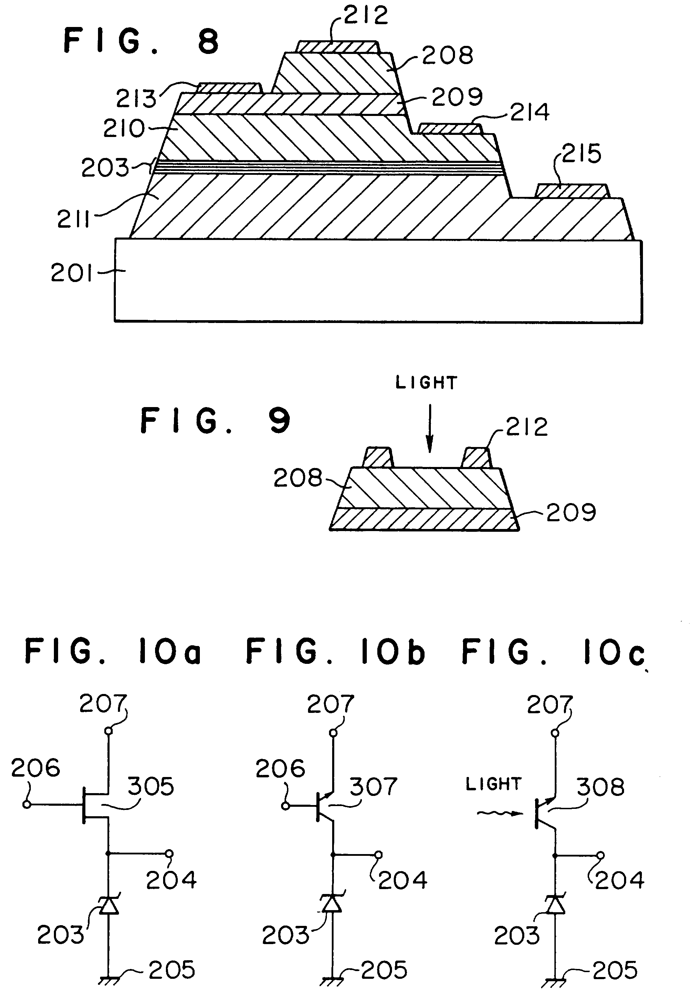

The equivalent circuit of the structure of the semiconductor device indicated in Fig. 7 stated above is indicated in Fig. 10a, in which reference numeral 305 represents an FET.

When the terminal 204 of the circuit indicated in Fig. 10a as described above is connected with the gate of another FET, it is possible to construct the circuit indicated in Fig. 3 stated above. Namely, according to the present EMBODIMENT, it is possible to form easily circuits indicated in EMBODIMENT 3 in Fig. 3 stated above on a same substrate and thus to integrate easily a number of variable conductance circuits indicated in EMBODIMENT 3.

The numerical values used here of the thickness of the channel layer, the carrier density, the thickness of the quantum well layer, etc. are not at all absolute and also the material is not restricted to GaAs, but InGaAs, AlGaAs, etc. may be used therefor as well. In short, the essential feature of the present invention is that the multiple barrier diode is integrated on the FET structure. Further the electrode arrangement is not necessarily that indicated in Fig. 7. For example, the output electrode 204 may be disposed on the channel layer 202 between the gate electrode 206 and the multiple negative differential resistance diode 203 or on the side wall of the diode.

EMBODIMENT 5

Fig. 8 is a cross-sectional view of a semiconductor device, in which the part of the multiple negative differential resistor and a load bipolar transistor of still another multiple level variable conductance according to the present invention is realized.

In Fig. 8, an n conductivity type GaAs channel layer 211, a multiple level negative resistance diode layer 203, an n conductivity type GaAs collector layer 210 (n: $5 \times 10^{16}/cm^3$, 400 nm (4000 Å) thick), a p conductivity type GaAs base layer 209 (p: $1 \times 10^{19}/cm^3$, 100 nm thick) and an n conductivity type $Al_{0.3}Ga_{0.7}As$ emitter layer 208 (n: $1 \times 10^{17}/cm^3$, 200 nm thick) are emitter layer 208 (n: $1 \times 10$ /cm , 200 nm thick) are formed on an semi-insulating GaAs substrate 201, and ohmic electrode 212, 213, 214 and 215 are formed further thereon.

The electrode 213 stated above is made of an AuZn alloy and the other electrodes are made of AuGe. They form ohmic contacts with the respective p and n conductivity type layers.

The equivalent circuit of the multiple level variable conductance described in the present embodiment is indicated in Fig. 10b. That is, in the present embodiment, the load element is a bipolar transistor 307, whose emitter, base and collector are composed of the layers 208, 209 and 210, respectively, and with which the multiple negative resistance diode 203 is connected in series.

In the present embodiment it is possible to obtain an effect similar to that obtained by the semiconductor device indicated in EMBODIMENT 4 described above by applying a suitable bias to the base of the bipolar transistor 307.

Further, although, in the present embodiment, a GaAs/AlGaAs heterojunction bipolar transistor is used, it may be replaced by a homojunction transistor. Furthermore it is a matter of couse that a similar effect may be obtained also by using a heterojunction made of another material, e.g. InGaP/GaAs. InAlAs/InGaAs, etc., or a homojunction made of them.

EMBODIMENT 6

Fig. 9 shows the sixth embodiment of the present invention and is a partial cross-sectional view thereof indicating only the part of the emitter 208 and the base 209 in Fig. 8 stated above.

In the present invention a window is formed in the emitter electrode 212 as indicated in the figure so that light can enter the surface of the emitter from the exterior. In this way the bipolar transistor acts as a phototransistor 308.

The equivalent circuit of the multiple level variable conductance described in the present embodiment is indicated in Fig. 10c.

In the present embodiment it is possible to use a light pulse instead of a voltage or current pulse from the exterior for switching over the conductance.

Although the emitter electrode 212 of the bipolar transistor indicated in the present embodiment is made of AuGe, if a transparent electrode made of e.g. $In_2O_3$, $SnO_2$, etc. is used instead thereof, the window may not be necessarily formed in order to make light enter the emitter. Further, if light is made enter the emitter in the horizontal direction or in an oblique direction in the figure, a similar effect can be obtained also without forming any window.

EMBODIMENT 7

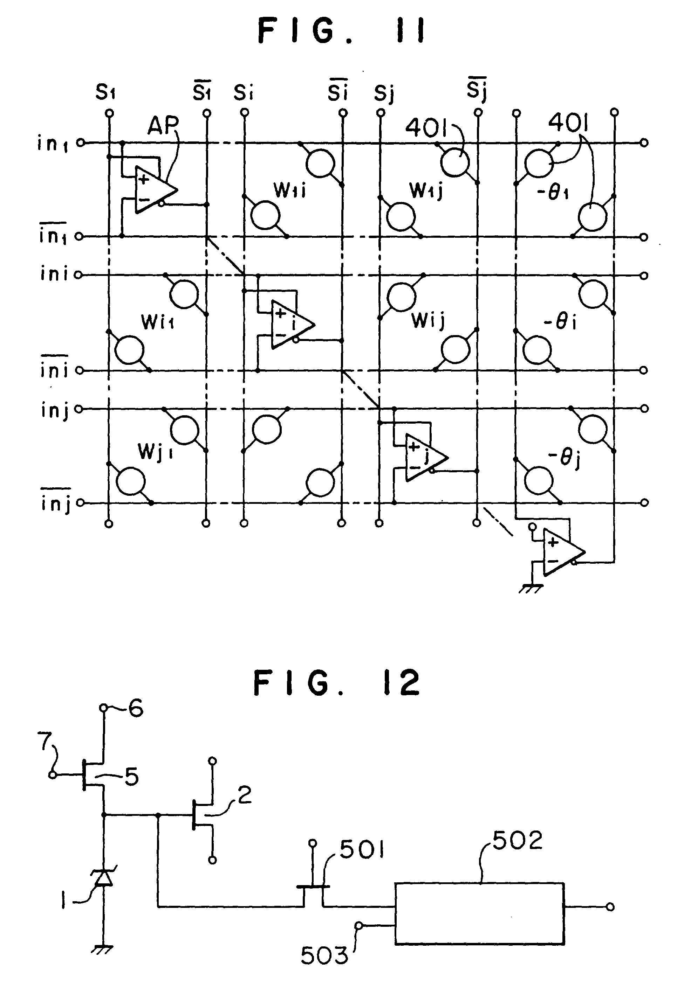

Fig. 11 is a scheme illustrating the circuit construction of an embodiment of the neuro chip, in which multiple level variable conductance circuits according to the present invention are used.

In Fig. 11, $in_l$ to $in_j$ and $\overline{in}_1$ to $\overline{in}_j$ represent input signals and their inverted signals, respectively. Further, the parts indicated by $\overline{W}_{ij}$ (i and j are natural numbers) are so-called synapses 401 (indicated by circular marks), which are multiple level variable conductance circuits described in EMBODIMENT 3 stated above. However, in this case, conductances variable in 8 levels are used therefor. for the synapse, the control voltage input terminal, etc. of the variable conductance circuit are omitted in the figure. Two terminals of the synapse 401 correspond to the two terminals of the FET 2 indicated in Fig. 3.

Each of the input lines is connected with an amplifier AP or one of axons Si, $\overline{S}$i, etc. through a synapse. Various sorts of inputs and signals from the axon are weighted through the synapse and inputted in the input terminal of each of the amplifiers AP and the output signal of the amplifier is outputted again to the axon. That is, the input signal has a feedback circuit of amplifier - axon - synapse - amplifier and owing to this feedback the potential of each of the axons is stabilized at a certain value, depending on the coupling between the input signal and the synapse. This is the so-called neuro computing and the potential of the axon, i.e. the potential of Si and $\overline{S}$i (i is a natural number), is the result of the operation.

In the present embodiment, a chip was fabricated with 6 amplifiers and 30 synapses (in Fig. 11 only a part thereof is indicated). The elements required therefor are 5 FETs per amplifier and 12 elements per synapse and therefore the total number of necessary elements is 390. On the contrary, in the case where the prior art variable conductance circuit indicated in Fig. 1b is used as the synapse, the necessary number of FETs per synapse is 36 and therfore in total 1110 FETs are necessary in order to realize the same function as the neuro chip described in the present embodiment. Consequently, according to the present embodiment it is possible to reduce significantly the number of elements and to decrease remarkably the area of the chip. Further, in the case where the variable conductance circuit indicated in Fig. 1b is used, when the conductance is variable in 8 levels, 8 input lines per synapse are necessary for determining the conductance of each synapse. On the contrary, in the present embodiment, independently of the number of levels of the variability of the conductance, since one input line is sufficient for every synapse, it is possible to reduce remarkably the number of wires.

EMBODIMENT 8

Fig. 12 is a circuit diagram of a circuit of multiple level variable conductance in which a reading-out FET 501, a discriminator circuit 502 and a reference input 503 are added to the circuit described in EMBODIMENT 3.

In the circuit indicated in Fig. 12, the reading-out FET 501 is usually turned-off and turned-on by applying a gate voltage thereto only at the read-out. Further the discriminator circuit 502 compares a signal from the reading-out transistor 501, i.e. the gate potential of the FET 2 serving as the variable conductance element (potential at the connecting point between the multiple negative differential resistance element 1 and the load FET 5) with the reference input 503 and outputs the difference therebetween and its sign in the form of signals. In this way it is possible to read-out the magnitude of the conductance of the variable conductance element 2 in a non-destructive manner.

As an example of utilization, this circuit can be used e.g. as the synapse 401 in the neuro chip in EMBODIMENT 7. When this circuit is used, the following points are made possible.

Firstly, since it is possible to read-out the state of coupling in the synapse, it is possible to copy completely the state of coupling of one neuro chip to another chip. The copy is effected as follows. At first, the state of coupling is read-out with a reference-input 503 of zero potential from a certain synapse on the chip to be copied and the signal thus obtained is used as a reference signal for the corresponding synapse in the destination chip. Then a signal pulse is inputted in the control voltage input terminal 7 of the destination synapse so that the output of the discriminator circuit 502 is zero. The copy of the state of coupling between different chips can be effected by repeating this procedure for all the synapses.

Secondly, it is possible to record the state of coupling in another medium, e.g. magnetic recording material, etc. by using a method similar to that used for the copy. It is called learning to vary the intensity in the coupling in the synapse so as to make the output of the neuro chip for a certain input be in accordance with an originally required output. According to the present embodiment it is possible to record and copy the result of learning.

According to the present invention it is possible to realize stably a multiple level variable conductance having a high precision and air excellent reproducibility with a small number of elements. Further the circuit according to the present invention has an effect that it can be easily integrated. Furthermore a number of excellent advantages can be obtained that a neuro chip, which can record and copy the state of coupling with a high precision, is realized, etc.

Now a case where an optical multi-stable device is used as the synapse will be described.

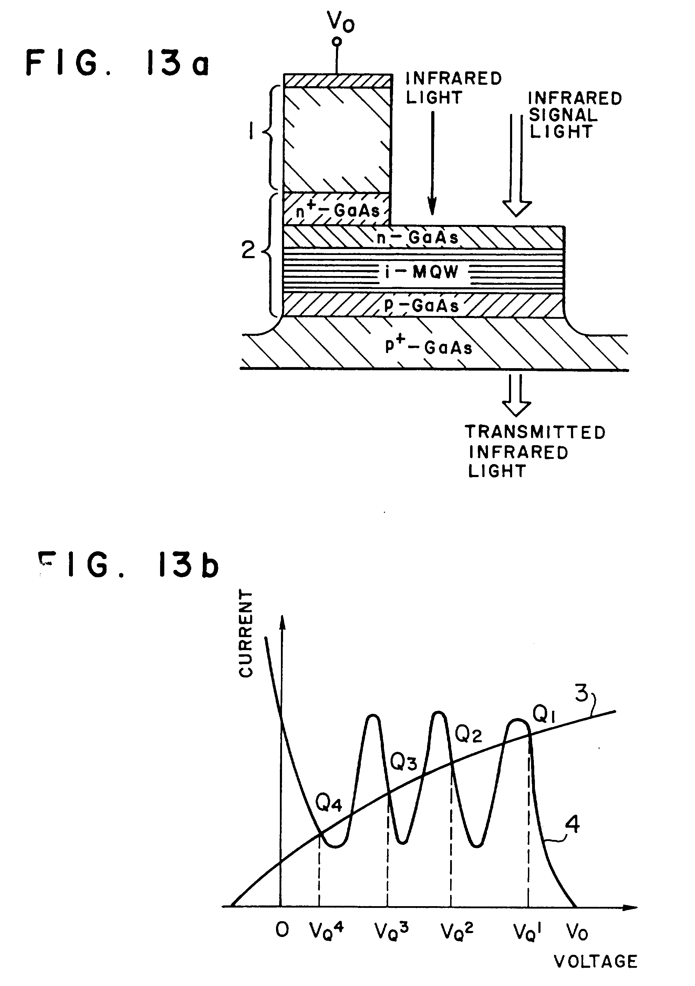

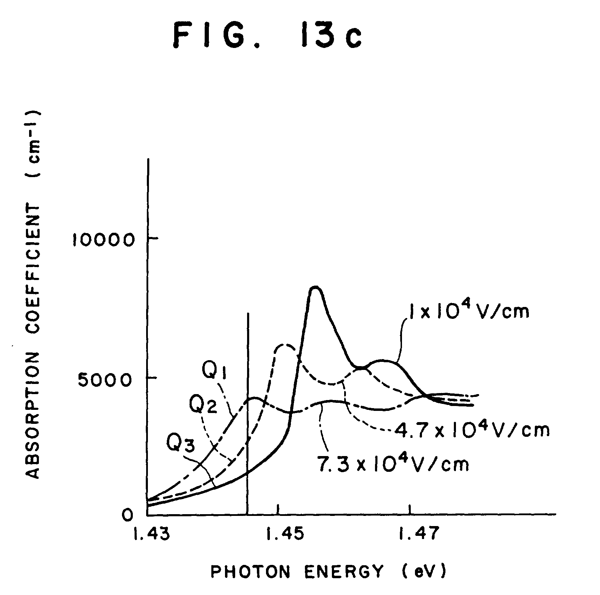

The optical multi-stable device stated above consists of a multiple negative differential resistance device 1 and a multiple quantum well (MQW) p-i-n diode 2 connected in series and has a plurality of stable points indicated by $Q_1$ to $Q_4$ with respect to the applied external voltage $V_0$ owing to the fact that the current-voltage curve 4 representing the characteristics of the multiple negative differential resistance device 1 stated above intersects with the current-voltage characteristic curve 3 of the MQW p-i-n diode 2. The stable points stated above are points of operation for the applied external voltage $V_0$ and the device does not operate at the points other than the stable points stated above. In this case, the photo-current (Iph) 3 of the MQW p-i-n diode (Fig. 13b) is controlled by infrared light, with which the device is irradiated. At this time, the switching-over among the stable points $Q_1$ to $Q_4$ stated above is effected by superposing a pulse voltage $\Delta V_0$ on the external voltage $V_0$. On the other hand, the absorption coefficient of the MQW p-i-n diode 2 for infrared light varies as indicated in Fig. 13c, depending on the intensity of the electric field applied to the MQW (as known as quantum confined Stark effect). Now, when an infrared light having an energy of 1.445 eV is used as optical signal for the system (indicated by a segment of a full line in the figure), the absorption coefficient of the MQW increases with increasing intensity of the electric field. For this reason, as the optical multi-stable device is switched-over as $Q_1 \rightarrow Q_2 \rightarrow Q_3$ among the stable points stated above, as described above, the absorption coefficient of the MQW for the signal light is decreased in multiple levels as $1 \rightarrow 2 \rightarrow 3$. Consequently, when the optical multi-stable device according to the present invention is used as the synapse, it is possible to set and store the absorption coefficient for the signal light in a multiple-valued logical manner and to rewrite easily the stored information by varying the external voltage.

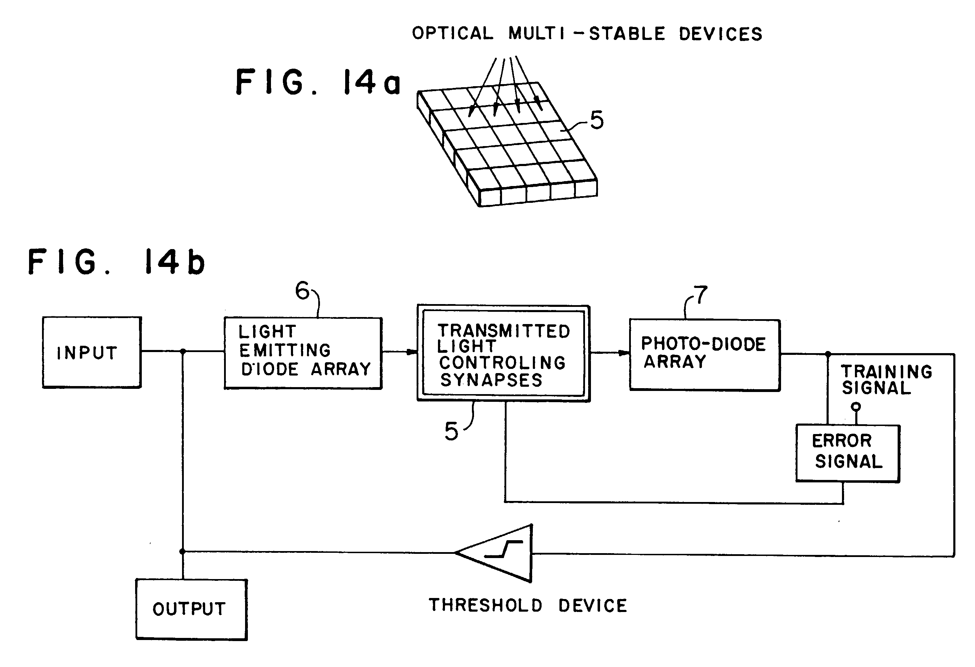

The optical multi-stable device can be arranged easily on one wafer in a matrix form, as indicated in Fig. 14a, and used as a transmitted light controlling synapse 5 rewritable in an optical neuro system. Fig. 14b indicates the construction of an optical neuro system using the optical multi-stable device according to the present invention and having the learning function. The signal projected by the light emitting diode array 6 is collected on a photodiode array 7 after having been treated by the transmitted light controlling synapse, in which optical multi-stable elements are arranged on a two-dimensional plane in a matrix form. The output signal thus obtained is compared with a training signal prepared previously. The result thereof is fedback to the transmitted light controlling synapse 5 in the form of a voltage pulse. The feedback signal stated above is applied to the external voltage terminal of each of the optical multi-stable elements to rewrite the stored information.

As described above, in the optical neuro system, in which optical multi-stable elements according to the present invention are used as the synapse, it is possible to rewrite stored information, which is inevitable for realizing the learning function, and further it is possible to integrate them.

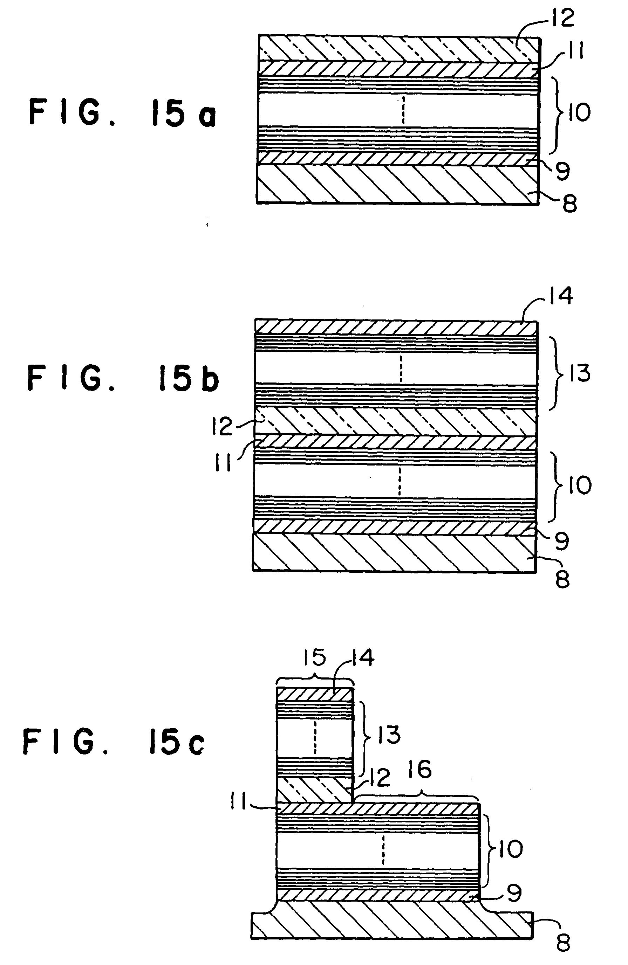

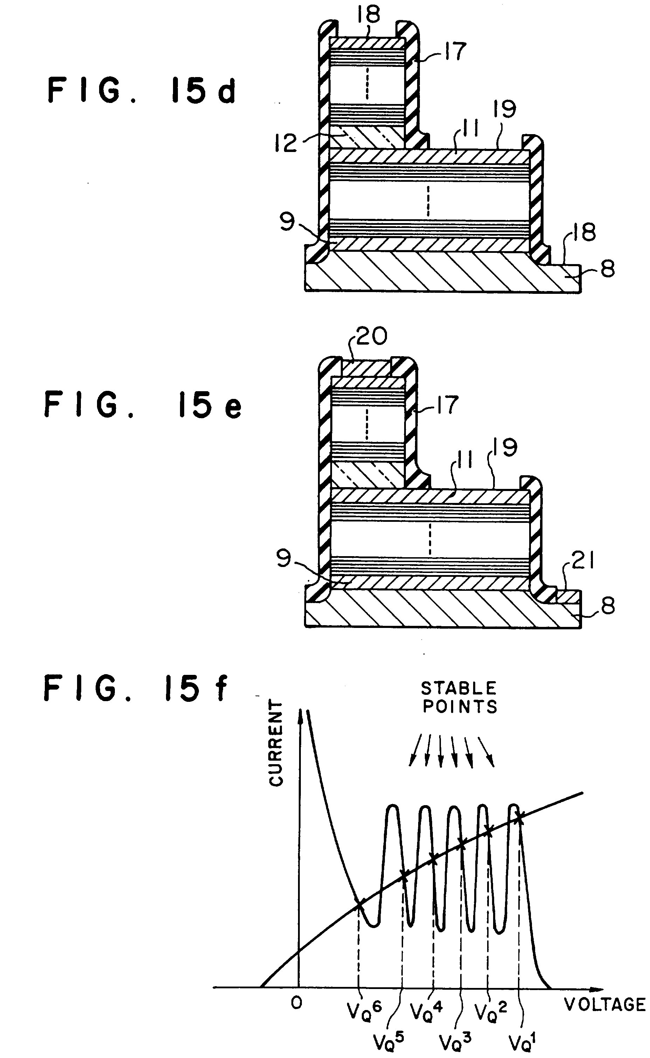

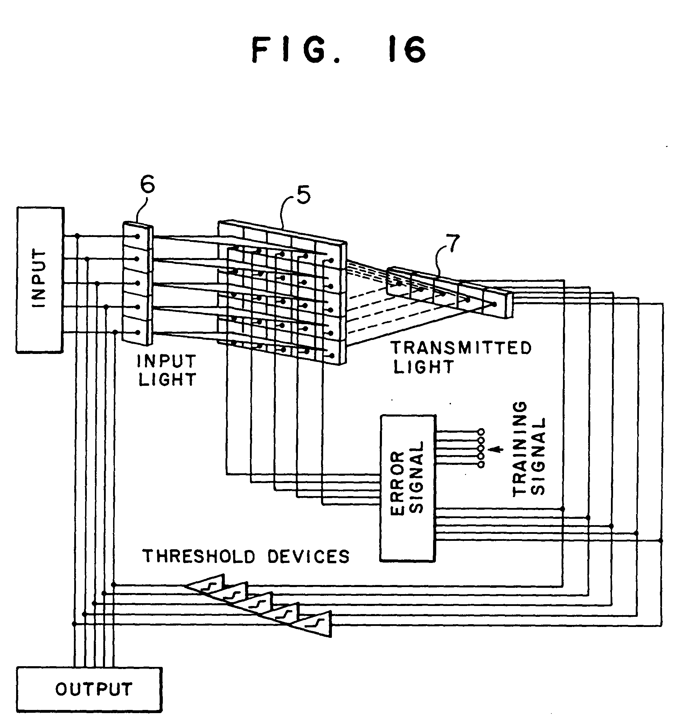

Fig. 15a to 15e show the fabrication steps of the optical multi-stable element in cross-section, which are an embodiment of the present invention; Fig. 15f is a scheme showing the operation thereof; and Fig. 16 is a scheme illustrating the construction of a pattern recognizing device, in which optical multi-stable elements according to the present invention are used as the synapse. The optical multi-stable device indicated in Figs. 15a to 15e as an embodiment is a device, in which a 5-layer structure diode having a double barrier resonant tunneling barrier structure is used as the multiple level negative differential resistance element. As indicated in Fig. 15a, a p conductivity type GaAs layer 9 (carrier concentration $3 \times 10^{17}/cm^3$, 50 nm thick) is grown on a $p^+$ conductivity type GaAs substrate 8 by the MBE method and thereafter an MQW structure layer 10 is grown. It is supposed that the MQW structure layer 10 stated above is fabricated by repeating 100 times to superpose, from the $p^+$ conductivity type GaAs substrate 8 side, an i-$Al_{0.3}Ga_{0.7}AS$ layer (2.5 nm thick)/i-GaAs layer (10 nm thick) as a barrier layer (a semiconductor thin layer having a wide band gap) and a well layer (a semiconductor thin layer having a narrow band gap), respectively. Thereafter an n conductivity type GaAs layer 11 (carrier concentration $3 \times 10^{17}/cm^3$, 50 nm thick) and an $n^+$ conductivity type GaAs layer 12 (carrier concentration $1 \times 10^{18}/cm^3$, 300 nm thick) are grown again by the MBE method. Then, as indicated in Fig.15b, a multiple level negative differential resistance portion 13 is grown by the MBE method. The multiple level negative differential portion 13 is constructed from the MQW structure side already grown, as indicated below. That is, a unit structure consists of 6 layers of $n^+$-GaAs layer (carrier concentration $1 \times 10^{18}/cm^3$, 50 nm thick)/i-GaAS layer (30 nm thick)/i-$Al_{0.3}Ga_{0.7}AS$ layer (5 nm thick)/i-GaAs layer (5 nm thick)/i-$Al_{0.3}Ga_{0.7}As$ layer (5 nm thick)/i-GaAs layer (30 nm thick). This unit structure is superposed 5 times and finally an $n^+$-GaAs layer 14 (carrier concentration $1 \times 10^{18}/cm^3$, 300 nm thick) is grown. A mesa region 15 and a signal light and control light incidence region 16 are formed by the usual photolithographic technique, as indicated in Fig. 15c.

Then an $SiO_2$ layer 17 (400 nm thick) is grown by the CVD method and electrode forming regions 18 and a signal light and control light incidence hole 19 are formed. Next, as indicated in Fig. 15e, a cathode electrode 20 and an anode electrode 21 are formed by the usual lift-off method. For forming them AuGe/Ni/ Au are deposited in thicknesses of 60/10/60 nm (600/100/600 Å), respectively, by evaporation.

The element fabricated as described above has 6 stable points, as indicated in Fig. 15f, and the transmission coefficient for the incident light, i.e. the stored information can be varied in 6 levels. A pattern recognizing device has been constructed by arranging an optical filter 5, in which optical multi-stable elements are arranged in an N x N matrix form, an array 6 consisting of N LEDs and an array 7 consisting of N photodiodes, as indicated in Fig. 6. An inputted two-dimensional pattern is represented by electric signals of N bits. They are transformed into light by the LED array 6 and thereafter the transmission coefficients of the transmitted light controlling synapses 5 therefor are weighted. The output signal is transformed into an electric signal by the photodiode array 7 and transmitted to a threshold value processing element. A part thereof is compared with a training signal previously given and fed back to the transmitted light controlling synapse 5 as an error signal. The signal stated above is applied to the external voltage terminal of the respective optical multi-stable element to rewrite the stored information (transmission coefficient). As described above, the present system can rewirte easily the stored information, which is indispensable for the learning function.

As explained above, the semiconductor device according to the present invention consists of a multiple negative differential resistance element having negative differential resistance characteristics at more than two places in the current-voltage chracteristics and a p-n junction diode having a multiple well structure.

## Claims

1. A semiconductor device having a multiple level variable conductance circuit formed on a substrate and comprising a series connection of

   multiple negative differential resistance diode means (1) having current-voltage characteristics with at least two negative differential resistance regions, and
   a load element (3, 4, 5),
   characterised in
   that said multiple negative differential resistance diode means (1) is formed by a resonant tunnelling barrier structure (13) having at least three potential barrier layers superposed on each other and comprises a terminal connected with said load element (3, 4, 5) to form a connection point of said series connection, and
   that said multiple level variable conductance circuit further comprises a variable conductance element (2) having a control terminal connected to said connecting point.

2. The semiconductor device according to claim 1, further including an external input terminal (7) disposed at the connecting point of said series connection or at said load element (5) on said substrate, wherein the conductance can be changed over from a certain value to another by inputting a signal through said external input terminal (7).

3. The semiconductor device according to claim 1 or 2, further comprising an amplifier (10) formed on said substrate and having a grounded first input terminal, a first output terminal and a second input terminal connected with said first output terminal through a feedback resistor (11), wherein said variable conductance element (2) of said multiple level variable conductance circuit is connected with said second input terminal of said amplifier (10).

4. The semiconductor device according to claim 1 or 2, wherein at least a field effect transistor, a bipolar transistor, a photodiode, a light emitting diode and a laser are integrated on said substrate together with said multiple negative differential resistance diode means (1).

5. A neuro chip comprising a plurality of means (401) corresponding to synapses acting as in/output interfaces in/from neurons and between neurons, and being composed of the semiconductor device according claim 1 or 2.

6. The neuro chip according to claim 5, wherein said synapses means (401) are arranged in a matrix form.

## Patentansprüche

1. Halbleiterbauelement mit einer auf einem Substrat ausgebildeten Schaltung mit einem variablen Mehrniveau-Leitwert, die eine Serienschaltung aus

   einer Diodeneinrichtung mit einem mehrfachen negativen differentialen Widerstand (1), die eine wenigstens zwei negative differentiale Widerstandsbereiche aufweisende Strom-Spannungskennlinie zeigt, und
   einem Lastelement (3, 4, 5) aufweist,
   dadurch **gekennzeichnet**,
   daß die Diodeneinrichtung mit einem mehrfachen negativen differentialen Widerstand (1) durch eine Resonant-Tunnelbarriere-Struktur (13) mit wenigstens drei aufeinander angeordneten Potentialbarriere-Schichten gebildet wird und einen mit dem Lastelement (3, 4, 5) verbundenen Anschluß zum Ausbilden eines Verknüpfungspunktes für die Serienschaltung aufweist, und
   daß die Schaltung mit einem variablen Mehrniveau-Leitwert weiter ein Element mit einem variablen Leitwert (2) aufweist, das einen mit dem Verknüpfungspunkt verbundenen Steueranschluß hat.

2. Halbleiterbauelement gemäß Anspruch 1, das weiter einen externen Eingangsanschluß (7) aufweist, der am Verknüpfungspunkt der Serienschaltung oder am Lastelement (5) auf dem Substrat angeordnet ist, wobei der Leitwert von einem bestimmten Wert auf einen anderen durch Eingeben eines Signals über den externen Eingangsanschluß (7) geändert werden kann.

3. Halbleiterbauelement gemäß Anspruch 1 oder 2, das weiter einen auf dem Substrat ausgebildeten Verstärker (10) aufweist, der einen geerdeten ersten Eingangsanschluß, einen ersten Ausgangsanschluß und einen mit dem ersten Ausgangsanschluß über einen Gegenkopplungswiderstand (11) verbundenen zweiten Eingangsanschluß hat, wobei das Element mit einem variablen Leitwert (2) der Schaltung mit einem variablen Mehrniveau-Leitwert mit dem zweiten Eingangsanschluß des Verstärkers (10) verbunden ist.

4. Halbleiterbauelement gemäß Anspruch 1 oder 2, wobei wenigstens ein Feldeffekttransistor, ein Bipolartransistor, eine Fotodiode, eine lichtemittierende Diode und ein Laser auf dem Substrat zusammen mit der Diodeneinrichtung mit einem mehrfachen negativen differentialen Widerstand (1) integriert sind.

5. Neurochip mit einer Vielzahl von Einrichtungen (401), die Synapsen entsprechen, die als Eingangs-/Ausgangs-Schnittstelle von/zu Neuronen und zwischen Neuronen wirken und aus Halbleiterbauelementen gemäß Anspruch 1 oder 2 bestehen.

6. Neurochip gemäß Anspruch 5, wobei die Synapseneinrichtungen (401) in Matrixform angeordnet sind.

**Revendications**

1. Dispositif à semi-conducteur comportant un circuit à conductance variable à niveaux multiples formé sur un substrat et constitué par la connexion en série

de moyens (1) formant diode à résistances différentielles négatives multiples ayant une caractéristique courant-tension comportant au moins deux zones à résistance différentielle négative, et
d'un élément de charge (3, 4, 5),
caractérisé en ce que
lesdits moyens (1) formant diode à résistances différentielles négatives multiples sont formés à l'aide d'une structure (13) à barrière, à effet tunnel, résonnante, comportant au moins trois couches formant barrière de potentiel superposées les unes aux autres, et comportent une borne connectée audit élément de charge (3, 4, 5) pour former un point de connexion de ladite connexion en série, et en ce que ledit circuit à conductance variable à niveaux multiples comporte en outre un élément (2) à conductance variable ayant une borne de commande connectée audit point de connexion.

2. Dispositif à semi-conducteur selon la revendication 1, comportant en outre une borne d'entrée externe (7) disposée au niveau du point de connexion de ladite connexion en série ou au niveau dudit élément de charge (5) sur ledit substrat, dans lequel la conductance peut être changée d'une certaine valeur à une autre valeur en envoyant un signal à travers ladite borne d'entrée externe (7).

3. Dispositif à semi-conducteur selon la revendication 1 ou 2, comportant en outre un amplificateur (10) formé sur ledit substrat et ayant une première borne d'entrée reliée à la masse, une première borne de sortie, et une seconde borne d'entrée connectée à ladite première borne de sortie à travers une résistance de rétroaction (11), dans lequel ledit élément (2) à conductance variable dudit circuit à conductance variable à niveaux multiples est connecté à ladite seconde borne d'entrée dudit amplificateur (10).

4. Dispositif à semi-conducteur selon la revendication 1 ou 2, dans lequel au moins un transistor à effet de champ, un transistor bipolaire, une photodiode, une diode électroluminescente et un laser sont intégrés sur ledit substrat en association avec lesdits moyens (1) formant diode à résistances différentielles négatives multiples.

5. Neuro-puce comportant plusieurs moyens (401) correspondant à des synapses agissant comme des interfaces d'entrée/sortie vers des neurones, à partir de neurones et entre neurones, et étant composée du dispositif à semi-conducteur selon la revendication 1 ou 2.

6. Neuro-puce selon la revendication 5, dans laquelle lesdits moyens (401) formant synapses sont agencés sous forme matricielle.

FIG. 1a
PRIOR ART

FIG. 1b
PRIOR ART

FIG. 2

FIG. 3

FIG. 4

# FIG. 5a

# FIG. 5b

# FIG. 6

# FIG. 7

FIG. 8

FIG. 9

LIGHT

FIG. 10a    FIG. 10b    FIG. 10c

# FIG. 11

# FIG. 12

FIG. 13a

FIG. 13b

15

# FIG. 13c

## OPTICAL MULTI-STABLE DEVICES

## FIG. 14a

## FIG. 14b

THRESHOLD DEVICE

EP 0 364 987 B1

FIG. 15a

FIG. 15b

FIG. 15c

FIG. 15d

FIG. 15e

FIG. 15f

# FIG. 16